# FASCICULE DE BREVET EUROPEEN

(11) **EP 2 705 529 B1**
(45) Date de publication et mention de la délivrance du brevet: **11.03.2015**
(21) Numéro de dépôt: 12723839.2
(22) Date de dépôt: 27.04.2012
(51) Int. Cl.: H01L 21/762

(54) **PROCEDE DE FORMATION D'UNE FRACTURE DANS UN MATERIAU**
VERFAHREN ZUR HERSTELLUNG EINES RISSES IN EINEM MATERIAL
PROCESS FOR FORMING A CRACK IN A MATERIAL

(30) Priorité: 02.05.2011 FR 1153737
(43) Date de publication de la demande: 12.03.2014
(73) Titulaire: Commissariat à l'Énergie Atomique et aux Énergies Alternatives, 75015 Paris (FR)
(72) Inventeur: TAUZIN, Aurélie, F-38120 St Egreve (FR); MAZEN, Frédéric, F-38100 Grenoble (FR)
(74) Mandataire: Ahner, Philippe
(86) Numéro de dépôt international: PCT/EP2012/057713
(87) Numéro de publication internationale: WO 2012/150184

(56) Documents cités:
- WO-A2-2004/042779
- WO-A2-2005/080645
- WO-A2-2007/110515
- BARBIER G ET AL: "Effects of lithium-implantation on the hydrogen retention in both a-C:H and a-SiC:H materials submitted to deuterium bombardment", JOURNAL OF NUCLEAR MATERIALS, ELSEVIER BV, NL, vol. 241-243, 11 février 1997 (1997-02-11) , pages 1036-1040, XP004403138, ISSN: 0022-3115, DOI: DOI:10.1016/S0022-3115(96)00655-1

## Description

### DOMAINE TECHNIQUE ET ART ANTERIEUR

L'invention concerne les procédés de réalisation de fracture dans des substrats, tels que des substrats semiconducteurs.

Elle s'applique notamment à la fabrication de couches minces pour la microélectronique.

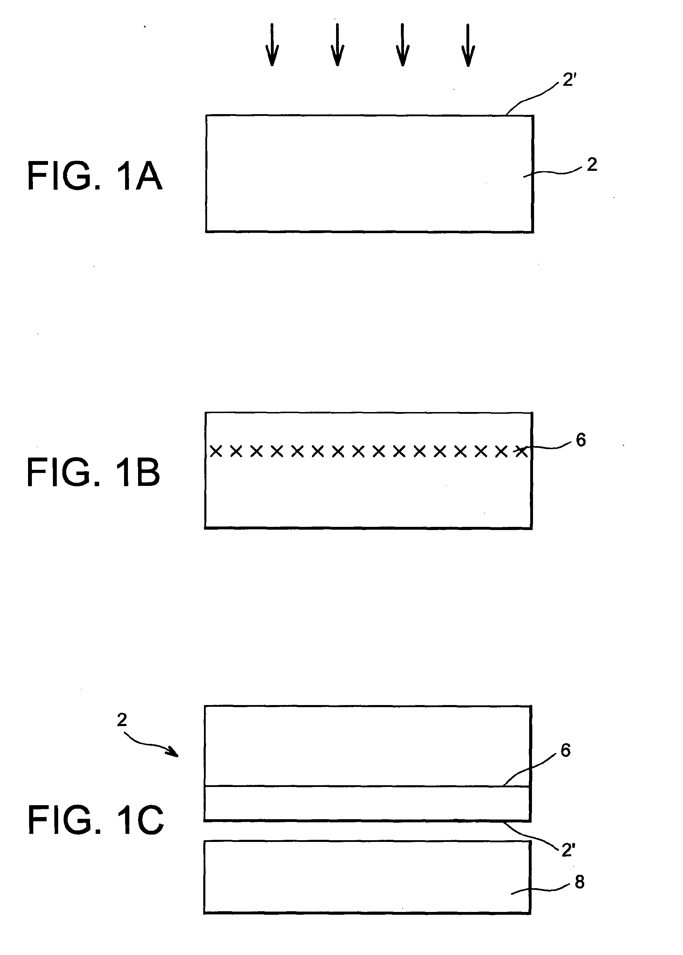

On connaît le procédé « Smart Cut »™, qui permet le détachement d'un film mince et son transfert sur un raidisseur selon les étapes suivantes, qui vont être décrites en liaison avec les figures 1A - 1D.

Dans une première étape (figure 1A) on réalise une implantation d'ions d'une (ou plusieurs) espèce gazeuse (par exemple l'hydrogène, l'hélium...), dans un substrat donneur 2, à travers une surface 2' de celui-ci. On forme ainsi une zone d'implantation 6, dont la concentration en ions est suffisante pour créer une couche de microcavités (figure 1B). L'implantation est généralement une implantation d'hydrogène ou d'hélium à une énergie de 10 à 210keV, et à une dose de quelques 10¹⁶ à 10¹⁷/cm².

La face 2' du substrat donneur 2 est ensuite mise en contact intime avec un substrat receveur 8 (figure 1C).

Il est ensuite procédé à une fracture au niveau de la zone 6 de microcavités, par l'application d'un traitement thermique et/ou d'une contrainte de détachement. Dans le cas d'un traitement thermique, celui-ci est réalisé par application d'une température dans une gamme sensiblement comprise entre 300°C et 700°C. Pour appliquer une contrainte de détachement on peut insérer une lame entre les deux substrats 2, 8 et/ou appliquer des efforts de traction et/ou de flexion et/ou de cisaillement, et/ou encore des ultrasons ou des micro-ondes.

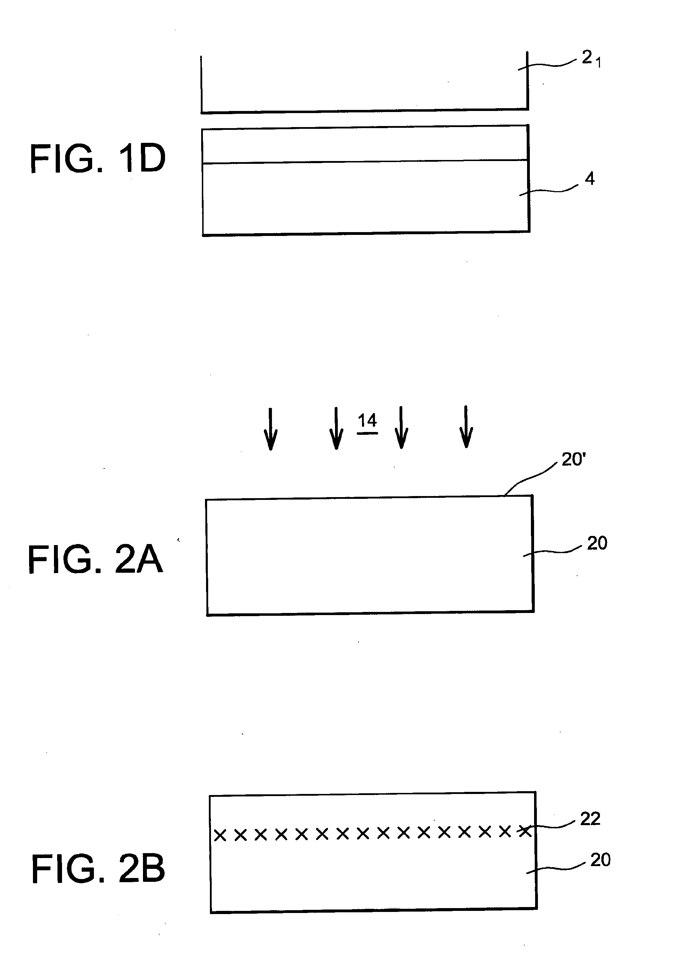

On obtient une fracture, et une couche 4 de matériau issu du substrat donneur 2, reportée sur le substrat receveur 8, comme illustré en figure 1D.

La portion restante 2₁ du substrat donneur 2 peut ensuite être recyclée et notamment réutilisée pour recommencer le même cycle.

Différentes variantes de ce procédé ont été proposées, afin de diminuer la dose d'implantation 4 nécessaire à la fracture, ou bien d'abaisser la température du traitement de fracture.

Ainsi, il est connu qu'une co-implantation He-H permet de diminuer la température de fracture et/ou la dose nécessaire pour obtenir la fracture, comme décrit dans l'article de C. Lagahe-Blanchard et al., Proceedings on the Semiconductor Wafer Bonding VII : Science, Technology, and Applications, Paris, France, 27 April-2 May 2003 Electrochemical Society, Pennington, NJ, 2003, Vol. PV2003-19, p. 346. Voir aussi le document WO2004/042779 publié le 21 Mai 2004.

Cette technique de co-implantation He-H est très efficace pour diminuer la dose totale nécessaire à la fracture, ou encore pour diminuer la température du recuit de fracture, ou même encore pour diminuer la rugosité des couches après fracture.

Mais cette technique est très sensible aux paramètres d'implantation. En particulier la distance relative entre les zones ou pics d'implantation, respectivement d'hydrogène et d'hélium, ou l'ordre dans lequel les implantations sont réalisées, ou encore le ratio de doses He/H influent fortement sur la dose totale ou sur la température de recuit de fracture ou sur les caractéristiques du film qui résulte de la fracture, voire sur l'obtention de la fracture elle-même.

Les conditions d'implantation optimales ne sont, aujourd'hui, pas identifiées. On trouve, dans la littérature, différentes indications, pas nécessairement cohérentes entre elles, relative à ces conditions.

Par ailleurs, les mécanismes de la co-implantation He-H apparaissent complexes, ce qui complique la mise en oeuvre de cette technique.

Selon une autre méthode, on sait, par les documents Appl. Phys. Lett., Vol. 72, p.49, 1998, ou US 5877077, qu'une co-implantation de bore et d'hydrogène permet de diminuer la température de fracture jusqu'à 200°C. L'implantation de Bore a de nombreux avantages : en particulier, cet élément est couramment utilisé en microélectronique, ce qui facilite son intégration pour un procédé industriel.

Mais le Bore est un atome plus lourd que l'hydrogène ou l'hélium. Il endommage donc plus le matériau du substrat dans lequel il est implanté, ce qui peut être néfaste pour la qualité des couches. Par ailleurs, pour une énergie d'implantation donnée, la profondeur d'implantation diminue quand la masse de l'ion augmente. Il n'est donc pas possible, avec un implanteur classique (limité en énergie) d'implanter du bore profondément (typiquement au-delà de 100nm).

Il se pose donc le problème de trouver un nouveau procédé ne présentant pas les limitations ci-dessus.

Il se pose également le problème de trouver un nouveau procédé permettant de réduire la dose d'implantation et/ou le budget thermique mis en oeuvre lors de la fracture.

### EXPOSÉ DE L'INVENTION

On décrit un nouveau procédé, mettant en oeuvre la formation d'une zone de forte concentration en lithium suivie d'une implantation d'hydrogène.

Ce procédé comporte:
- la formation dans un substrat de silicium d'une zone à forte concentration en lithium, avec une concentration comprise entre 5x10¹⁸ atomes/cm³ et 5x10²⁰ atomes/cm³,
- puis une implantation d'hydrogène dans ou au voisinage de la zone à forte concentration en lithium.

On peut donc réaliser un procédé de formation d'une couche de silicium à partir d'un substrat, dit substrat donneur, en silicium, comportant :
- la formation dans ledit substrat donneur, d'une zone à forte concentration en lithium, avec une concentration comprise entre 5x10¹⁸ atomes/cm³ et 5x10²⁰ atomes/cm³,
- puis une implantation d'hydrogène dans le substrat donneur, dans, ou au voisinage de, la zone à forte concentration en lithium,
- l'application d'un raidisseur avec le substrat donneur,
- l'application d'au moins un budget thermique pour conduire au détachement de la couche définie par l'implantation.

La formation d'une zone à forte concentration en lithium permet de former des pièges efficaces pour l'hydrogène, le lithium et l'hydrogène ayant notamment une forte affinité chimique.

La formation de la zone d'implantation de lithium peut être obtenue par une première implantation par des ions de lithium, par exemple à une dose supérieure à 1x10¹³/cm² (ou comprise entre 10¹³ et 5x10¹⁵/cm²). Les énergies d'implantation sont, dans ce cas, choisies de préférence de sorte que les pics de Li et d'H soient localisés entre eux à la même profondeur, ou situés à une faible distance l'un par rapport à l'autre, cette distance étant inférieure ou égale à, sensiblement, 200 nm ou 150nm. La différence de profondeur d'implantation peut être évaluée à l'aide de simulateurs classiquement utilisés dans le domaine de l'implantation depuis de nombreuses années. On peut citer à titre d'exemple le logiciel de simulation SRIM, disponible sur internet. Cette différence peut également être mesurée par Spectrométrie de masse à ionisation secondaire (connu sous l'acronyme SIMS).

Les doses d'implantation sont choisies telles que :
- la dose de lithium est inférieure à 5.10¹⁵ Li/cm², ce qui permet d'éviter l'amorphisation du substrat Si (la concentration maximale de Li est alors d'environ 4.10¹⁹/cm³, la limite d'amorphisation étant de 4.10²¹/cm³).
- la dose d'hydrogène est comprise entre 4.10¹⁶ et 10¹⁷ /cm².

En variante, le lithium est introduit dans le substrat donneur par électrolyse ou diffusion, par exemple après dépôt ou évaporation du lithium sur une surface du substrat.

L'implantation d'hydrogène est alors de préférence réalisée de manière à ce que le pic d'hydrogène (lieu de concentration maximal en hydrogène) soit localisé à une profondeur à laquelle la concentration de lithium dans le substrat Si est de l'ordre de 4.10¹⁹/cm³ ou comprise entre 5x10¹⁸/cm³ et 1x10²⁰/cm³. Là encore on peut prévoir, à l'aide des outils déjà mentionnés ci-dessus (SRIM ou SIMS), à quelle distance on a la concentration souhaitée.

Un avantage de cette variante est qu'elle ne nécessite qu'une seule implantation, précédée d'une étape à bas coût, par électrolyse ou diffusion.

Dans ce cas, le profil d'implantation du lithium est sensiblement constant depuis la surface jusqu'à une profondeur maximale d'introduction, on cherche alors à ce que la profondeur moyenne d'implantation de l'hydrogène dans le substrat donneur soit comprise dans cette zone.

La diffusion, après dépôt ou évaporation sur une surface du substrat, est par exemple réalisée par traitement thermique.

D'une manière générale, on peut réaliser une implantation d'hydrogène à une dose comprise entre 10¹⁶ atomes/cm² et 5.10¹⁷ atomes/cm².

Le budget thermique étant abaissé, par rapport au cas d'une implantation unique, le substrat donneur et le raidisseur peuvent avoir des coefficients de dilatation thermique dont la différence est, en valeur absolue, supérieure à 3.10⁻⁶K⁻¹.

Un procédé tel qu'on vient de le décrire permet de diminuer significativement le traitement thermique de fracture et/ou la dose totale d'implantation.

La mise en oeuvre de ce procédé décrit ci-dessus est plus aisée que la co-implantation He-H : il suffit, en effet, que le lithium soit introduit en premier, et que les espèces Li et H soient à proximité l'une de l'autre. De plus, le lithium est un élément léger, plus léger que le bore, les couches transférées sont donc de meilleure qualité cristalline et il est possible avec un implanteur standard de transférer des couches plus épaisses qu'avec du bore (facilement jusqu'au micron en cas d'implantation et même au-delà en cas de diffusion).

### BRÈVE DESCRIPTION DES DESSINS

Les figures 1A - 1D représentent des étapes d'un procédé connu.
Les figures 2A - 2F représentent des étapes d'un nouveau procédé d'implantation.
Les figures 3A - 3D sont des vues illustrant des comparaisons du cloquage par implantation d'hydrogène seul (figures 3A et 3B) ou par co-implantation de lithium et d'hydrogène suivie d'un recuit à 450°C pendant 10minutes (figures 3C et 3D).
Les figures 4A et 4B sont des diagrammes donnant, respectivement, la concentration en lithium diffusé en fonction de la profondeur et la solubilité du Li dans le silicium.

### EXPOSÉ DÉTAILLÉ DE MODES DE RÉALISATION PARTICULIERS

On décrit un nouveau procédé de formation de double implantation, à l'aide des figures 2A - 2D.

Dans une première étape (figure 2A) on sélectionne un substrat 20 en silicium éventuellement muni d'une couche superficielle d'oxyde thermique SiO₂.

Cet oxyde (non représenté spécifiquement sur les figures) peut avoir une épaisseur de quelques dizaines ou centaines de nm, par exemple 50 nm ou 100nm.

On réalise, dans ce substrat, une implantation de lithium, à l'aide d'un faisceau 14 d'ions lithium, dirigé à travers une face 20' du substrat. On aboutit donc à la formation d'une zone 22 implantée en lithium (figure 2B). En fait, la référence 22 désigne le pic d'implantation de lithium, ou zone de concentration maximum située à 960nm sous la surface implantée pour une énergie d'implantation de 210keV.

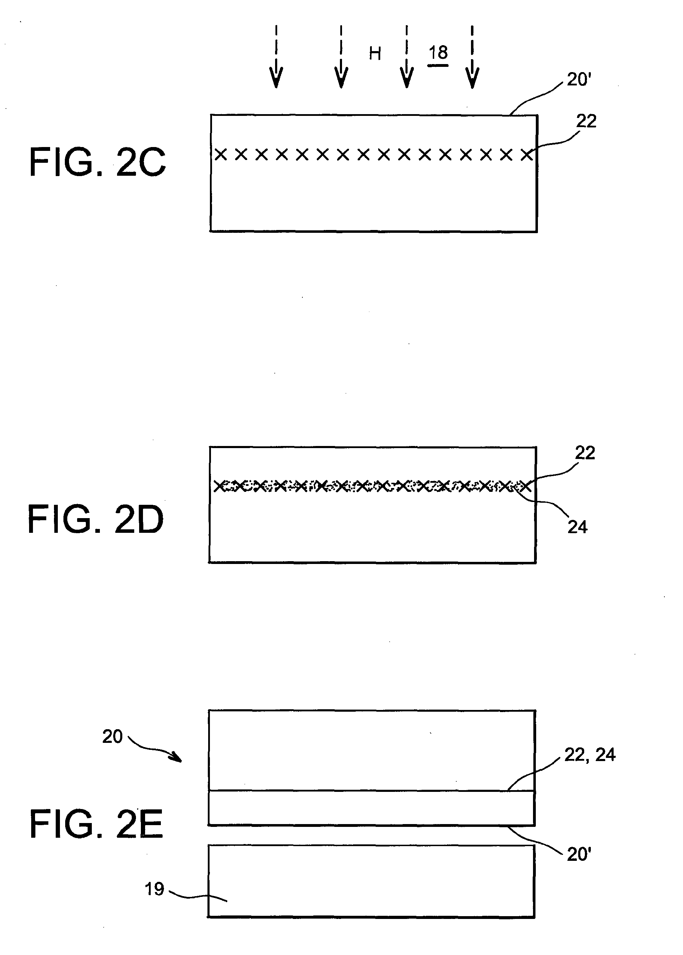

On réalise ensuite (figure 2C) une implantation 18 d'ions hydrogène, à travers la même face 20' du substrat 20 que celle à travers laquelle l'implantation de lithium a été effectuée. On aboutit donc à la formation d'une zone implantée en hydrogène, dont le pic d'implantation est identifié sur la figure 2C par la référence 24 (figure 2D), située sensiblement à la même profondeur que le pic d'implantation de lithium.

La face 20' d'implantation du substrat 20 est ensuite mise en contact intime avec un raidisseur 19 (figure 2E), par exemple en saphir.

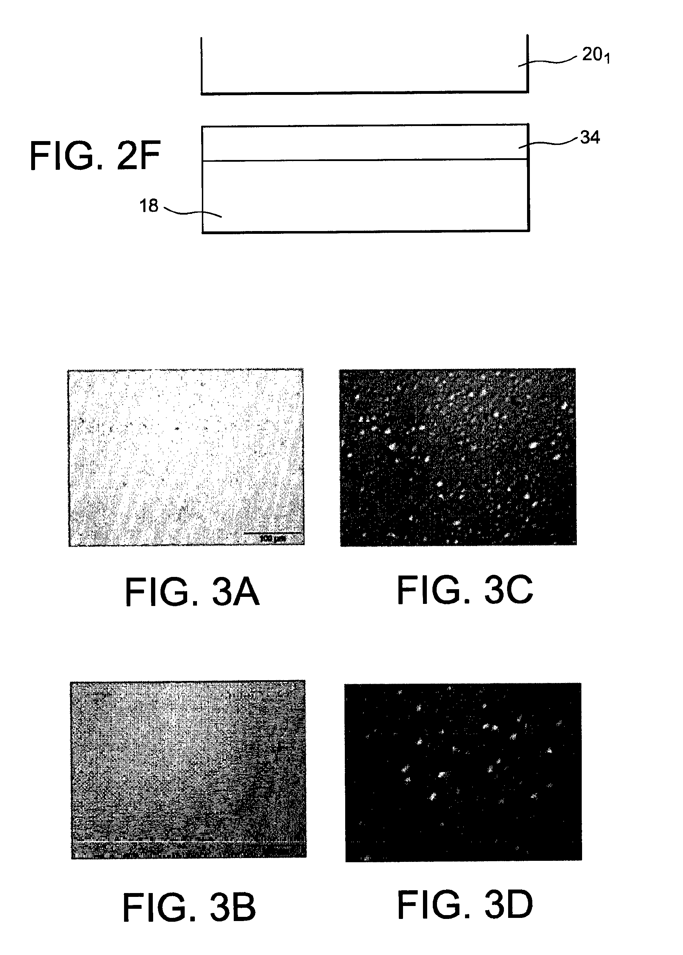

Il peut être ensuite procédé à une fracture au niveau de la couche de microcavités, par l'application d'un traitement thermique et/ou d'une contrainte de détachement (figure 2F).

Dans le cas d'un traitement thermique, on applique une température dans une gamme sensiblement comprise entre 150°C et 700°C, et typiquement entre 200°C et 400°C.

Pour appliquer une contrainte de détachement on peut insérer une lame au niveau de la zone implantée 22, 24 du substrat 20 et/ou on applique des efforts de traction et/ou de flexion et/ou de cisaillement au substrat 20, et/ou encore des ultrasons ou des micro-ondes de puissance et de fréquence dans la gamme 10 à 100kHz, par exemple entre 10 et 50kHz, par exemple 40kHz.

On obtient une fracture le long de la zone implantée 22, 24, comme illustré en figure 2F, avec formation d'une couche mince 34 en silicium 20 et éventuellement de la couche d'oxyde, et une portion restante 20₁ du substrat 20, qui peut ensuite être recyclée et notamment réutilisée pour recommencer le même cycle.

En variante, une zone 22 à forte concentration en lithium peut être réalisée par une étape d'introduction du lithium, par électrolyse ou par diffusion. L'étape de la figure 2A est donc remplacée par cette étape d'électrolyse ou de diffusion. Le profil d'implantation est alors constant depuis la surface jusqu'à quelques microns (10microns), voire quelques dizaines de microns (100 microns).

Dans le cas de l'introduction de lithium par électrolyse, on peut procéder comme décrit dans l'article de A.M.Mousa, intitulé « Profiling of lithium and potassium into silicon », Turk J Phys, 30, 2006, 15-20: un substrat en silicium est utilisé comme cathode, et est plongé, avec une anode, dans un bain d'un sel de lithium (par exemple : LiBr) utilisé comme électrolyte. L'électrolyse est réalisée pendant une durée comprise par exemple entre 5 minutes et 30 minutes, avec un courant compris entre 1 mA et quelques dizaines de mA, par exemple 30 mA. On peut évaluer la distribution du lithium en fonction de sa profondeur dans le substrat par mesure de résistance par la méthode des 4 points. On peut calibrer préalablement ces mesures par des observations MEB (microscopie électronique à balayage).

Dans le cas de l'introduction par diffusion, on peut procéder comme décrit dans l'article de A.Keffous et al., intitulé «Lithium diffusion profile onto highly resistive p-type silicon », Vacuum, 81, 2006, 417-421. Le lithium est préalablement déposé sur un substrat en Silicium, par évaporation thermique sous vide, par exemple à quelques 10⁻⁶ Torr. La diffusion proprement dite a lieu par recuit sous vide, à plusieurs centaines de degrés, par exemple comprise entre 300° C et 800° C, pendant une durée comprise entre quelques minutes et quelques dizaines de minutes, par exemple entre 5 mn et 30 mn. Là encore, on peut évaluer la distribution du lithium en fonction de sa profondeur dans le substrat par mesure de résistance par la méthode des 4 points. Là encore, on peut calibrer préalablement ces mesures.

La mise en oeuvre de l'une ou l'autre de ces techniques est suivie, comme en figure 2C :
- d'une implantation 18 d'ions hydrogène, pour aboutir à la formation d'une double implantation hydrogène - lithium, comme sur la figure 2D,
- puis d'une mise en contact intime avec un raidisseur 19 (figure 2E),
- et, enfin, d'une fracture au niveau de la couche de microcavités, par l'application d'un traitement thermique et/ou d'une contrainte de détachement (figure 2F).

On présente maintenant des résultats expérimentaux, qui seront illustrés à l'aide des figures 3A - 3D, sur lesquelles :
- la figure 3A est un cliché de la surface du substrat implanté après une implantation d'hydrogène, seul, à 100 keV avec une dose de 4,5.10¹⁶ H/cm²,
- la figure 3B est un cliché de la surface du substrat implanté après une implantation d'hydrogène, seul, à 110 keV avec une dose de 4,5.10¹⁶ H/cm²,
- la figure 3C est un cliché de la surface du substrat implanté après une double implantation, une première implantation de lithium à 210 keV avec une dose de 10¹⁵ H/cm² suivie par une deuxième implantation d'hydrogène à 100 keV avec une dose de 4,5.10¹⁶ H/cm²,
- la figure 3D est un cliché de la surface du substrat implanté après une double implantation, une première implantation de lithium à 210 keV avec une dose de 10¹⁵ H/cm² suivie par une deuxième implantation d'hydrogène à 110 keV avec une dose de 4,5.10¹⁶ H/cm².

On examine ici la densité de cloques qui se forment en surface du substrat Si implanté, lorsque ce substrat n'est pas collé à un substrat support.

En effet, ces cloques sont révélatrices de la présence de microfissures sous-jacentes, dont la pression de gaz (H₂ dans le cas d'une implantation d'hydrogène) entraîne une déformation de surface ; elles sont donc directement reliées aux microfissures formées lorsqu'on réalise un assemblage avec un substrat de report puis une fracture, comme en figures 1C - 1D dans le cas d'une implantation avec de l'hydrogène seul, ou en figures 2E - 2F dans le cas d'une coimplantation lithium - hydrogène. Les clichés des figures 3A et 3B montrent qu'une implantation d'hydrogène seul ne permet pas la formation de cloques en surface des substrats.

Par contre (figures 3C et 3D) l'introduction de Li par implantation, avant l'implantation d'hydrogène, permet l'obtention de cloques très développées, voire même de zones exfoliées, dans les mêmes conditions de recuit que précédemment.

Ceci montre donc l'influence bénéfique de la double implantation selon l'invention. En effet, pour que le procédé de fracture fonctionne de manière satisfaisante, on cherche à ce que la pression dans les cavités soit suffisante. Pour les faibles profondeurs d'implantation, un raidisseur (collé ou déposé) permet de favoriser l'expansion latérale des microfissures et d'obtenir la fracture. Si ce raidisseur n'est pas présent (c'est le cas dans les résultats présentés ici), la montée en pression des cavités se traduit par l'apparition de cloques en surface voire de zones exfoliées (ces cloques éclatent localement). Si, sans raidisseur, des cloques apparaissent en surface en densité suffisante, il suffira d'ajouter un raidisseur pour obtenir un transfert de film. Donc, pour faciliter l'étude du mécanisme de transfert, on se ramène à l'étude du cloquage en l'absence de raidisseur.

La co-implantation Li-H est donc un moyen très efficace pour diminuer le budget thermique et/ou la dose d'hydrogène nécessaire à l'obtention d'une fracture.

Ceci a pour conséquence, notamment, d'autoriser un report sur un substrat 19 présentant un coefficient de dilatation thermique (CTE) assez ou très différent de celui du premier substrat 20. Par exemple cette différence est d'au moins 2.10⁻⁶/K ou 3.10⁻⁶/K, ce que l'on trouve notamment lorsqu'on a un substrat de Si d'une part et un substrat de saphir d'autre part (CTE(Si) = 2,31.10⁻⁶/K et CTE(saphir) = 6,35.10⁻⁶/K).

On donne maintenant des exemples de réalisation.

### Exemple 1 :

Un substrat 20 en Silicium (100) est muni d'une couche d'oxyde thermique SiO₂ d'épaisseur 100nm.

Il est implanté dans les conditions suivantes, les étapes étant celles des figures 2A -2F :
- on réalise une première implantation de lithium, à une énergie de 210keV et avec une dose de 10¹⁵/cm²,
- puis on effectue une deuxième implantation d'hydrogène, à une énergie de 100keV et avec une dose de 4,5x10¹⁶/cm².

Le substrat implanté est ensuite collé à un substrat en saphir 19 par collage ou assemblage direct ou moléculaire (figure 2E).

On obtient après collage une hétérostructure Si/Saphir. Les coefficients de dilatation thermique (CTE) du Si et du saphir étant très différents (CTE Si = 2,31.10⁻⁶/K et CTE saphir = 6,35.10⁻⁶/K), le collage Si/saphir ne peut pas être porté à une température supérieure à ~350°C : au-delà de cette température, on assiste au décollement systématique des structures.

Le traitement de fracture consiste alors par exemple en un recuit à 250°C pendant 1h

Après fracture on obtient un film de Si reporté sur un substrat Saphir.

Par comparaison, une implantation en hydrogène seul aurait nécessité, pour le recuit de fracture, une température plus élevée, ce qui aurait abouti au décollement des substrats de Si et de saphir, ou à un temps de recuit plus long, ce qui n'est pas acceptable industriellement.

### Exemple 2 :

Un substrat de Si de type P (111) est soumis à l'introduction de lithium par diffusion, dans les conditions suivantes :
- une couche de Li est d'abord déposée en surface du Si par évaporation sous vide (à 2.10⁻⁶ Torr), à température ambiante,
- puis il est procédé à une diffusion du Li dans le Si, par un recuit sous vide (1.10⁻⁵ Torr), à 800°C pendant 10min.

L'excès de Li sur la surface du substrat Si est ensuite éliminé en rinçant la plaque dans du méthanol.

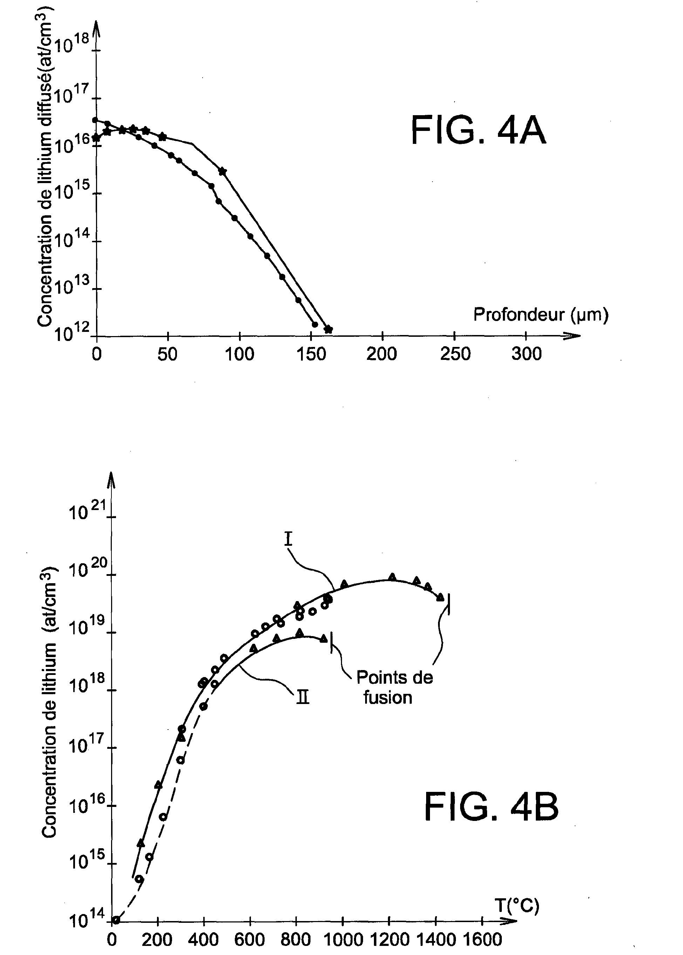

On obtient alors un profil de diffusion typique, similaire à celui présenté sur la figure 4A, tirée de l'article de A.Keffous et al. déjà cité ci-dessus, mais avec des niveaux de concentration en Li plus élevés (sur cette figure, les * correspondent à des valeurs expérimentales, avec une température de diffusion de 425°C et une durée de diffusion de 4 min ; les points circulaires noirs correspondent à des résultats de simulation PCID, dans les mêmes conditions ). En effet, la concentration en Li à la surface du substrat (ou encore à une profondeur nulle sur la figure 4A) correspond à la solubilité du Li dans le Si, dont la courbe est représentée sur la figure 4B, tirée, elle, de l'article de C.S.Fuller, intitulé « Interactions between solutes in Germanium and silicon », paper presented before the division of inorganic chemistry at the 134th meeting of the American Chemical Society, Chicago, Illinois, 1958. A 800°C, la concentration de Li dans le substrat Si est de ~4.10¹⁹/cm⁻³ depuis la surface jusqu'à une profondeur de quelques microns sous la surface. En figure 4B, les résultats relatifs au silicium sont donnés sur la courbe I, la courbe II correspondant au germanium.

On réalise ensuite l'implantation d'hydrogène dans les conditions suivantes :
- énergie de l'Hydrogène : 210keV
- dose : 4.10¹⁶ H/cm².

Le substrat implanté est ensuite collé à une plaque de Si 19 comportant une couche d'oxyde SiO₂ d'épaisseur 400nm en surface.

Une fracture est provoquée thermiquement, par l'application d'un recuit dans la gamme des 500°C.

Dans le cas d'une implantation par de l'hydrogène seul (à une énergie de 210keV et à une dose de 4.10¹⁶ H/cm²), il est impossible d'obtenir une fracture thermique à 500°C, la dose d'implantation étant trop faible.

L'exemple présenté ci-dessus montre bien qu'il est possible de diminuer la dose d'hydrogène nécessaire à la fracture, tout en ne mettant en oeuvre qu'une seule implantation (le Li étant introduit par diffusion, c'est-à-dire par un procédé à bas coût).

Cette variante est particulièrement intéressante pour diminuer le coût global d'un procédé de transfert.

## Revendications

1. Procédé de formation d'une couche (34) de matériau semi-conducteur à partir d'un substrat (20), dit substrat donneur, en ce même matériau semi-conducteur, comportant :
- la formation dans ledit substrat donneur, d'une zone (22) à forte concentration en lithium, avec une concentration comprise entre 5x10¹⁸ atomes/cm³ et 5x10² atomes/cm³,
- puis une implantation d'hydrogène (18, 24) dans le substrat donneur, dans, ou au voisinage de, la zone à forte concentration en lithium,
- l'assemblage du substrat donneur implanté avec un raidisseur (19),
- l'application d'un budget thermique pour conduire au détachement de la couche (34) définie dans le substrat donneur (20) par l'implantation.

2. Procédé selon la revendication 1, la température du budget thermique étant comprise entre 150°C et 700°C, et la durée d'application de ce cette température étant comprise entre 1 minute et 1 mois.

3. Procédé selon l'une des revendications 1 ou 2, le lithium étant introduit par implantation ionique (14).

4. Procédé selon la revendication 3, le lithium étant introduit à une dose supérieure à 1x10¹³/cm² ou comprise entre 10¹³/cm² et 5x10¹⁵/cm².

5. Procédé selon la revendication 1 ou 2, le lithium étant introduit par électrolyse ou diffusion.

6. Procédé selon la revendication 5, le lithium étant introduit par diffusion, après dépôt ou évaporation sur une surface du substrat.

7. Procédé selon la revendication 6, la diffusion, après dépôt ou évaporation sur une surface du substrat, étant réalisée par recuit.

8. Procédé selon l'une des revendications 1 à 7, les ions hydrogène étant implantés (18) à une dose comprise entre 10¹⁶ atomes/cm² et 5.10¹⁷ atomes/cm².

9. Procédé selon l'une des revendications 1 à 8, la profondeur moyenne d'implantation de l'hydrogène (24) dans le substrat donneur (20) étant différente de la profondeur moyenne (22) du lithium d'une valeur inférieure à 200 nm.

10. Procédé selon l'une des revendications 1 à 9, l'assemblage du substrat donneur implanté avec un raidisseur (19) étant de type assemblage ou collage moléculaire ou direct.

11. Procédé selon l'une des revendications 1 à 10, le substrat donneur (20) étant en silicium.

12. Procédé selon la revendication 11, le substrat de silicium étant oxydé en surface.

13. Procédé selon l'une des revendications 1 à 11, le raidisseur (18) étant en saphir.

14. Procédé selon l'une des revendications 1 à 13, le substrat donneur et le raidisseur ayant des coefficients de dilatation thermique dont la différence est, en valeur absolue, supérieure à 3.10⁻⁶K⁻¹.

## Patentansprüche

1. Verfahren zum Bilden einer Schicht (34) aus Halbleitermaterial ausgehend von einem Substrat (20), Donorsubstrat genannt, aus diesem gleichen Halbleitermaterial, umfassend:
- das Bilden eines Bereichs (22) mit starker Lithium-Konzentration, mit einer Konzentration zwischen 5 x 10¹⁸ Atomen/cm³ und 5 x 10²⁰ Atomen/cm³, in dem Donorsubstrat,
- dann eine Implantation von Wasserstoff (18, 24) in das Donorsubstrat in den bzw. nahe bei dem Bereich starker Lithium-Konzentration,
- das Zusammenfügen des implantierten Donorsubstrats mit einer Versteifung (19),
- das Aufbringen eines Wärmeeintrags, um das Lösen der in dem Donorsubstrat (20) definierten Schicht (34) durch die Implantation zu bewirken.

2. Verfahren nach Anspruch 1, wobei die Temperatur des Wärmeeintrags zwischen 150 °C und 700 °C liegt und die Dauer der Anwendung dieser Temperatur zwischen 1 Minute und 1 Monat beträgt.

3. Verfahren nach einem der Ansprüche 1 oder 2, wobei das Lithium durch Ionen-Implantation (14) eingebracht wird.

4. Verfahren nach Anspruch 3, wobei das Lithium mit einer Dosis eingebracht wird, die höher als 1 x 10¹³/cm² ist oder zwischen 10¹³/cm² und 5 x 10¹⁵/cm² liegt.

5. Verfahren nach Anspruch 1 oder 2, wobei das Lithium durch Elektrolyse oder Diffusion eingebracht wird.

6. Verfahren nach Anspruch 5, wobei das Lithium durch Diffusion nach Abscheiden oder Aufdampfen auf eine Fläche des Substrats eingebracht wird.

7. Verfahren nach Anspruch 6, wobei die Diffusion nach Abscheiden oder Aufdampfen auf eine Fläche des Substrats durch Tempern erfolgt.

8. Verfahren nach einem der Ansprüche 1 bis 7, wobei die Wasserstoffionen in einer Dosis zwischen 10¹⁶ Atomen/cm² bis 5.10¹⁷ Atomen/cm² implantiert werden (18).

9. Verfahren nach einem der Ansprüche 1 bis 8, wobei die durchschnittliche Implantationstiefe von Wasserstoff (24) in das Donorsubstrat (20) sich von der durchschnittlichen Tiefe (22) von Lithium um ein Maß von unter 200 nm unterscheidet.

10. Verfahren nach einem der Ansprüche 1 bis 9, wobei das Zusammenfügen des implantierten Donorsubstrats mit einer Versteifung (19) durch molekulare oder direkte Anordnung bzw. Haftung erfolgt.

11. Verfahren nach einem der Ansprüche 1 bis 10, wobei das Donorsubstrat (20) Silicium ist.

12. Verfahren nach Anspruch 11, wobei das Siliziumsubstrat an der Oberfläche oxidiert wird.

13. Verfahren nach einem der Ansprüche 1 bis 11, wobei die Versteifung (18) aus Saphir besteht.

14. Verfahren nach einem der Ansprüche 1 bis 13, wobei das Donorsubstrat und die Versteifung Wärmedehnungskoeffizienten aufweisen, deren Differenz im Absolutwert über 3.10⁻⁶K⁻¹ beträgt.

## Claims

1. Process for forming a layer (34) of semiconductor material from a substrate (20), or donor substrate, made of the same semiconductor material, comprising:
- formation in said donor substrate of a high lithium concentration zone (22), with a concentration between 5x10¹⁸ atoms/cm³ and 5x10²⁰ atoms/cm³,
- then an hydrogen implantation (18, 24) in the donor substrate, in, or in the vicinity of, the high lithium concentration zone,
- assembly of the donor substrate implanted with a stiffener (19),
- application of a thermal budget to result in the detachment of the layer (34) defined in the donor substrate (20) by the implantation.

2. Process according to claim 1, the thermal budget temperature being between 150°C and 700°C, and the application time of said temperature being between 1 minute and 1 month.

3. Process according to one of claims 1 or 2, lithium being introduced by means of ion implantation (14).

4. Process according to claim 3, lithium being introduced at a dose greater than 1x10¹³/cm² or between 10¹³/cm² and 5x10¹⁵/cm².

5. Process according to claim 1 or 2, lithium being introduced by means of electrolysis or diffusion.

6. Process according to claim 5, lithium being introduced by mean of diffusion, after deposition or evaporation on a surface of the substrate.

7. Process according to claim 6, the diffusion, after deposition or evaporation on a surface of the substrate, being performed by means of annealing.

8. Process according to one of claims 1 to 7, the hydrogen ions being implanted (18) at a dose between 10¹⁶ atoms/cm² and 5.10¹⁷ atoms/cm².

9. Process according to one of claims 1 to 8, the mean implantation depth of hydrogen (24) in the donor substrate (20) being different to the mean depth (22) of lithium by a value less than 200 nm.

10. Process according to one of claims 1 to 9, the assembly of the implanted donor substrate with a stiffener (19) being of the molecular or direct assembly or bonding type.

11. Process according to one of claims 1 to 10, the donor substrate (20) being made of silicon.

12. Process according to claim 11, the silicon substrate being oxidised on the surface.

13. Process according to one of claims 1 to 11, the stiffener (18) being made of sapphire.

14. Process according to one of claims 1 to 13, the donor substrate and the stiffener having thermal expansion coefficients wherein the difference is, in absolute terms, greater than 3.10⁻⁶K⁻¹.
